# EUROPÄISCHE PATENTANMELDUNG

(11) **EP 1 420 312 A2**
(43) Veröffentlichungstag der Anmeldung: **19.05.2004**
(21) Anmeldenummer: 03026036.8
(22) Anmeldetag: 12.11.2003
(51) Int. Cl.: G05B 19/418

(54) **Verfahren, Vorrichtung, computerlesbarer Speicher und Computerprogramm-Element zum rechnergestützten Überwachen und Regeln eines Herstellungsprozesses**

(30) Priorität: 12.11.2002 DE 10252605
(71) Anmelder: Infineon Technologies AG, 81669 München (DE)
(72) Erfinder: Märitz, Jörn, 93152 Zeiler-Nittendorf (DE)
(74) Vertreter: Viering, Jentschura & Partner

(57) **Zusammenfassung**

Verfahren, Vorrichtung, computerlesbarer Speicher und Computerprogramm-Element zum rechnergestützten Überwachen und Regeln eines Herstellungsprozesses.

Bei einem Verfahren zum rechnergestützten Überwachen und Regeln eines Herstellungsprozesses einer Mehrzahl von physikalischen Objekten werden die physikalischen Objekte mindestens einem Herstellungsschritt unterzogen und mindestens eines der prozessierten physikalischen Objekte gemäß einem deterministischen Auswahlkriterium so markiert, dass es einer Testmessung unterzogen werden kann. Ferner wird basierend auf dem Ergebnis der Testmessung des markierten Objektes der Herstellungsprozess geregelt.

## Beschreibung

Die Erfindung betrifft ein Verfahren, eine Vorrichtung, einen computerlesbaren Speicher und ein Computerprogramm-Element zum Überwachen und Regeln eines Herstellungsprozesses.

Bei der Herstellung von hochintegrierten Halbleiterchips auf Wafern werden insbesondere durch die immer weiter steigende Miniaturisierung der Strukturen auf dem Halbleiterchip immer höhere Anforderungen an die für die Herstellung der Halbleiterchips verwendeten Fertigungsanlagen und Herstellungsprozesse auftreten. Die Stabilität und Reproduzierbarkeit sowohl der Fertigungsanlagen als auch der Herstellungsprozesse beeinflussen maßgeblich die Ausbeute und Produktivität im Rahmen der Halbleiterchip-Fertigung. Schon kleine Abweichungen von einem Soll-Verhalten einer Wafer-Fertigungsanlage im Rahmen der Produktion können zu einer erheblichen Verschlechterung der Ausbeute, das heißt zu einer erheblichen Erhöhung der Fehlerrate bei den hergestellten Halbleiterchips führen.

Im Allgemeinen werden die Halbleiterchips zu mehreren auf so genannten Wafern hergestellt. Ferner werden im Herstellungsprozess mehrere gleiche Wafer zu einer logistischen Einheit, einem Los, gruppiert und gemeinsam Halbleiter-Prozessschritten unterzogen.

Zum vollständigen und exakten Bestimmen der Produktqualität der Wafer eines Loses oder des Herstellungsverfahrens dieser Wafer müssten an sich alle Halbleiterchips nach deren Fertigstellung Testmessungen zum Bestimmen ihrer Eigenschaften und Qualität unterzogen werden. Dies würde aber einen viel zu großen zeitlichen und kostenmäßigen Aufwand fordern. Deshalb wird zum Bestimmen der Qualität der auf den Wafern angeordneten hergestellten Halbleiterchips gemäß dem Stand der Technik das so genannte Statistical Process Control (SPC) Verfahren verwendet. Bei dem SPC-Verfahren wird aus dem Los von Wafern statistisch eine Stichprobe von Wafern ausgewählt, an welchen Wafern dann Testmessungen zum Bestimmen der Qualität der Wafer vorgenommen werden. An Hand der Ergebnisse dieser Testmessung wird auf die Qualität der Wafer des gesamten Loses zurückgeschlossen. Man nimmt an, dass die Qualität aller Wafer des Loses dann um die gemessenen Qualitätswerte schwanken wird. Die so bestimmten Qualitätswerte gehen sowohl in die Bestimmung des cp-Wertes, welcher eine Aussage über die Breite einer Verteilung der Messwerte ist, oder anders ausgedrückt ein Maß für den kleinstmöglichen Anteil fehlerhafter Einheiten (Wafer) im Prozess, der bei zentrierter Lage der Verteilung erwartet wird, als auch in die Bestimmung des cpk-Wertes ein, welcher ein Wert ist, der angibt wie zentrisch die Verteilung der Messwerte zu einer vorgegebenen Spezifikation liegt, oder anders ausgedrückt ein Maß für den erwarteten Anteil fehlerhafter Einheiten im Prozess.
Ein wesentlicher Aspekt bei der Herstellung von Halbleiterchips ist auch, mögliche Abweichungen von einem Soll-Verhalten bei einer Chip-Fertigungsanlage oder im Rahmen eines Herstellungsprozesses frühzeitig zu erkennen und entsprechende Gegenmaßnahmen zu treffen. Damit kommt der Analyse und der Überwachung von Maschinen, insbesondere der Chip-Fertigungsanlagen sowie der Herstellungsprozesse eine sehr hohe wirtschaftliche Bedeutung zu. Ferner ist die Analyse und Überwachung vieler Prozessschritte des Herstellungsprozesses von erheblicher Bedeutung, da üblicherweise nur selten eine Reparatur eines Zwischenprodukts nach Durchführung eines Prozessschrittes möglich ist. In der Regel ist im Rahmen des SPC-Verfahrens ein Funktionstest eines hergestellten Halbleiterchips erst am Ende des Herstellungsprozesses vorgesehen, was dazu führt, dass eine Rückkopplung der ermittelten Ergebnisse in den Herstellungsprozess erst sehr spät möglich ist. Auch führen Messungen am Ende des Herstellungsprozesses zu unspezifischen Ergebnissen in dem Sinne, dass eine eventuelle schlechte Produktionsqualität des Wafers nicht mehr unbedingt mit einem bestimmten Prozessierungsschritt in Verbindung gebracht werden kann.

Es ist ferner bekannt, in-line-Messungen von Prozess-Zwischenergebnissen, so genannte in-line-SPC-Messungen, beispielsweise der Schichtdicken, des Schichtwiderstands oder von Linienbreiten, etc. mittels des SPC-Verfahrens vorzunehmen. Dies führt zu zusätzlichen Messschritten im Rahmen des gesamten Herstellungsprozesses und ist somit zeitund kostenaufwändig, erhöht aber die Zuordenbarkeit von eventuellen Qualitätsmängeln zu einem bestimmten Prozessierungsschritt.

Ferner ist ein Verfahren zum Verbessern des Herstellungsprozesses mittels kontinuierlicher Anpassungen an die Bedürfnisse und festgestellten Mängel der hergestellten Wafer das so genannte Run-to-Run-Verfahren bekannt. Bei Verwenden des Run-to-Run-Verfahrens wird der Herstellungsprozess ständig und fortwährend ("von Lauf zu Lauf") aufgrund von gemessenen Prozessergebnissen, d.h. Messungen an den hergestellten Produkten oder Zwischenprodukten, geregelt. Es werden in kurzen Zeitabständen Prozessparameter eines Prozessierungsschrittes aufgrund gemessener Produktergebnisse geregelt. Die Regelung mittels des Run-to-Run-Verfahrens wird mittels so genannter Run-to-Run-Controllern durchgeführt.

Zum Durchführen des Run-to-Run-Verfahrens sind jedoch Messungen an Wafern nötig, um deren Produktqualität zu bestimmen und daraufhin die Prozessparameter zu regeln. Da Messungen zum Bestimmen der Produktqualität, wie schon erwähnt sowohl zeit- als auch kostenintensiv sind, werden die in-line-SPC-Messungen an zufällig ausgewählten Wafern als Eingangsgrößen für die Regelung mittels des Run-to-Run-Verfahrens verwendet. Diese in-line-SPC-Messungen werden verwendet, um die benötigten Angaben über die Produktqualitäten zur Verfügung zu stellen, auf Grund deren das Run-to-Run-Verfahren den weiteren Produktionsprozess steuern kann.

Aus [1] ist ein Verfahren und eine Anordnung zur Prozesssteuerung einer Halbleiterfabrikation bekannt, in welchem ein Los basierter Verwaltungs-Computer eine Verwaltung von Wafern, wobei ein Los als Einheit verwendet wird, mittels Verwaltens einer Prozessbedingung für jedes Los durchführt.

Aus [2] ist ein Advanced Process Control (APC) Framework bekannt, welches durch das Design und die Entwicklung eines Software Frameworks, welches Produktionsstätte, Verfahren und Equipment-Steuerungssystem integriert, automatisch Prozesssteuerungsoperationen durchführt.

Aufgabe der Erfindung ist es die Funktionsfähigkeit von Run-to-Run-Controllern zu gewährleisten bzw. zu erhöhen sowie die cp-Werte und cpk-Werte zu erhöhen.

Das Problem wird durch das Verfahren, die Vorrichtung, das computerlesbare Speichermedium und das Computerprogramm-Element zum Überwachen und Regeln eines Herstellungsprozesses mit den Merkmalen gemäß den unabhängigen Patentansprüchen gelöst.

Bei einem Verfahren zum rechnergestützten Überwachen und Regeln eines Herstellungsprozesses einer Mehrzahl von physikalischen Objekten werden die physikalischen Objekte mindestens einem Herstellungsschritt unterzogen und mindestens eines der prozessierten physikalischen Objekte gemäß einem deterministischen Auswahlkriterium so markiert, dass es einer Testmessung unterzogen werden kann. Ferner wird basierend auf dem Ergebnis der Testmessung des markierten Objektes der Herstellungsprozess geregelt.

Die Vorrichtung zum Überwachen und Regeln eines Herstellungsprozesses eines physikalischen Objektes weist mindestens einen Prozessor auf, der so eingerichtet ist, dass die oben beschriebenen Verfahrensschritte durchgeführt werden können.

In einem computerlesbaren Speichermedium ist ein Bearbeitungsprogramm zum Überwachen und Regeln eines Herstellungsprozesses eines physikalischen Objektes gespeichert, welches Bearbeitungsprogramm, wenn es von einem Prozessor ausgeführt wird, die oben beschriebenen Verfahrensschritte aufweist.

Ein Computerprogramm-Element zum Überwachen und Regeln eines Herstellungsprozesses eines physikalischen Objektes, weist die oben beschriebenen Verfahrensschritte auf, wenn es von einem Prozessor ausgeführt wird.

Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Unter einer Chip-Produktionsanlage ist im Rahmen der Beschreibung ein System bzw. eine Anordnung zu verstehen, in der unter Verwendung unterschiedlicher Rohmaterialien, beispielsweise unter Verwendung von Halbleiter-Materialien wie Silizium oder auch anderer IV-Hauptgruppen-Halbleiter-Materialien (beispielsweise Germanium) oder binären, ternären oder auch quaternären III-V-Verbindungshalbleiter-Materialien (beispielsweise Indium-Gallium-Arsenid-Phosphid, Indium-Gallium-Arsenid-Antimonid, etc.), oder binären, ternären oder auch quaternären II-VI-Verbindungshalbleiter-Materialien Halbleiter-Bauelemente, insbesondere Halbleiterchips gefertigt werden.

Unter einem Halbleiterchip ist im Rahmen dieser Beschreibung beispielsweise ein Speicher-Chip, ein Mikroprozessor-Chip, ein Kommunikations-Chip, ein Chip mit einem integrierten Halbleiter-Laser-Element, zu verstehen sowie ein auf eine beliebig vorgebbare Hardware-Funktion optimierter Chip wie beispielsweise ein Kommunikations-Chip zur Decodierung empfangener Funksignale oder ein Chip für die Verarbeitung von Videosignalen.

Die Chip-Produktionsanlage weist mehrere Teil-Produktionsanlagen auf, beispielsweise unterschiedliche Maschinen, mit denen die für den gesamten Herstellungsprozess eines Chips notwendigen physikalischen oder chemischen Prozessschritte durchgeführt werden können.

Ein Beispiel insbesondere in dem Front-End-Bereich der Chip-Fertigung sind Vorrichtungen zum Durchführen der folgenden Prozessschritte:
- eine Kurzzeittemper-Vorrichtung (Rapid Thermal Processing-Vorrichtung, RTP-Vorrichtung),
- ein Ofen zum Erhitzen der zu bearbeitenden Wafer,
- eine Ätzvorrichtung, beispielsweise eine Plasmaätz-Vorrichtung, oder eine Trockenätz-Vorrichtung,
- eine Lithographie-Vorrichtung,
- eine Nassbehandlungs-Vorrichtung zum Ätzen, Lackentfernen, Reinigen oder Verändern der Produkt-Oberfläche,
- eine CMP-Vorrichtung, d.h. eine Vorrichtung zum Durchführen chemisch-mechanischen Polierens,
- eine Ionen-Implantations-Vorrichtung,
- eine Abscheide-Vorrichtung zum Abscheiden von Schichten auf den Wafer, beispielsweise eine Abscheide-Vorrichtung zum physikalischen Abscheiden aus der Gasphase (Physical Vapour Deposition, PVD) oder zum chemischen Abscheiden aus der Gasphase (Chemical Vapour Deposition, CVD),
- eine Messvorrichtung zum Messen vorgegebener Waferparameter oder Prozessparameter,
- eine Test-Vorrichtung zum Testen hergestellter Wafer.

Je nach dem jeweils herzustellenden Produkt, beispielsweise je nach gewünschter Ausgestaltung des zu fertigenden Chips, ist eine Vielzahl unterschiedlicher Vorrichtungen, das heißt Teil-Produktionsanlagen in der Chip-Produktionsanlage vorgesehen und miteinander gekoppelt zur Realisierung des jeweiligen notwendigen Gesamt-Halbleiterchip-Fertigungsprozesses.

Es ist in diesem Zusammenhang anzumerken, dass der Ablauf der einzelnen Prozessschritte in den jeweiligen Teil-Produktionsanlagen entweder "sequentiell", d.h. immer zuerst in einer ersten Anlagengruppe A (z.B. belacken) vor zweiten Anlagengruppe B (z.B. belichten) durchgeführt werden können für zwei Herstellungsschritte die nacheinander stattfinden sollen, oder "parallel", d.h. in einer ersten Anlage B1 (z.B. Scanner Typ XY100) oder einer zweiten Anlage B2 (z.B. Stepper Typ Extra2000) für zwei verschiede Anlagen und Prozesse, die alternativ ein und den selben Herstellungsschritt durchführen können.

Mittels der Erfindung ist es möglich die Funktionsfähigkeit von Controllern, welche einen Herstellungsprozess regeln, sicherzustellen. Da die physikalischen Objekte, an denen Testmessungen durchgeführt werden, nicht, wie gemäß dem Stand der Technik, zufällig ausgewählt werden, sondern mittels deterministischer Regeln, d.h. Regeln welche gerade nicht zufällig sind, ausgewählt werden, kann es beispielsweise nicht dazu kommen, dass Lose, welche einer Testmessung unterzogen werden müssen, da an hand dieser Lose eine Regelung eines nachfolgenden Prozessschrittes erfolgen soll, nicht gemessen werden. Ein Algorithmus, welcher zur Regelung des Herstellungsprozesses verwendet wird, kann somit nicht mehr aufgrund mangelnder oder mangelhafter Ergebnissen von Testmessungen versagen. Durch das Verwenden von deterministischen Regeln, welche SPC-Messungen eines Herstellungsprozesses und Auswahlkriterien der Regelung des Herstellungsverfahrens berücksichtigen, wird gewährleistet, dass das Optimum an Losen oder Wafern gemessen wird. Es werden nur die Mindestanzahl von Messungen durchgeführt, welche für eine korrekte Überwachung und Regelung des Herstellungsprozesses benötigt werden.

Das Verfahren kann ein Run-to-Run-Verfahren sein.

Vorzugsweise ist das physikalische Objekt ein Wafer.

Insbesondere bei der Waferherstellung mit ihrer extrem hohen Zahl von Prozessschritten mit sehr hohen Anforderungen an die Produktionsqualität eignet sich die Erfindung gut, da eine automatisierte verbesserte Qualitätskontrolle und Regelung des Herstellungsverfahrens auf einfache Weise realisiert ist. Ferner besteht keine Gefahr, dass eine Regelung des Herstellungsverfahrens durch fehlende Messungen an Wafern oder Losen von Wafern unterbrochen wird, während gleichzeitig das Herstellungsverfahren nicht durch unnötige SPC-Messungen verlangsamt wird.

In einer Weiterbildung ist die Testmessung eine in-line-SPC-Messung.

In einer Ausgestaltung wird das deterministische Auswahlkriterium mittels Regeln bestimmt.

Vorzugsweise wird mindestens ein sowohl für das Run-to-Run-Verfahren als auch für das in-line-SPC-Verfahren notwendige Wafer ausgewählt.

Mittels der Erfindung ist es möglich, Kriterien eines Verfahrens zum Regeln eines Herstellungsprozesses, vorzugsweise eines Run-to-Run-Verfahrens, in den Standardproduktionsablauf zu integrieren. Im Gegensatz zu dem Stand der Technik, bei dem das Sampling, d.h. die Auswahl der Mehrzahl von physikalischen Objekten, unabhängig von Kriterien des Verfahrens zum Regeln des Herstellungsprozesses durchgeführt wird, wird im erfindungsgemäßen Verfahren das Sampling, insbesondere von Wafern, nach Kriterien durchgeführt, welche neben den Kriterien des Standardproduktionsablauf, d.h. vorzugsweise des in-line-SPC-Verfahrens, auch die Kriterien für ein Verfahren zum Regeln des Herstellungsprozesses erfüllen. Durch diese Integration wird auch gewährleistet, dass Run-to-Run-Regelschleifen, d.h. Regelschleifen, welche von dem Run-to-Run-Verfahren geregelt werden, unterbrechungslos arbeiten. Gemäß dem Stand der Technik kann es nämlich vorkommen, dass das Run-to-Run-Verfahren versagt, da z.B. in einer feed-forward Schleife, d.h. einer Regelschleife, in welcher auf Grund eines Ergebnisses einer Messung ein nachfolgender Prozessierungsschritt geregelt wird, ein Los nicht gemessen wird, und somit der zum Regeln benötigte Messwert nicht zur Verfügung steht. Dieser fehlende Wert kann in einem Verfahren gemäß dem Stand der Technik zu einem Versagen des Run-to-Run-Verfahrens im Folgeprozess führen. Demgegenüber ist erfindungsgemäß mittels der deterministischen Auswahlkriterien sichergestellt, dass die für eine Regelung benötigten Werte dem Verfahren zum Regeln des Herstellungsprozesses immer zur Verfügung stehen.

Anschaulich kann die Erfindung darin gesehen werden, dass die Erfindung eine automatisierte Auswahl von Stichproben mittels methodischer Anwendung von Regeln schafft. Die Regeln stellen sicher, dass immer die für ein Qualitätsmessverfahren (vorzugsweise ein SPC-Verfahren) und ein Verfahren zum Regeln des Herstellungsprozesses (vorzugsweise ein Run-to-Run-Verfahren) notwendigen Lose, und Wafer gemessen werden, um die für die Qualitätsüberwachung und die Regelung des Herstellungsprozesses benötigten Messdaten zu erhalten. Ferner werden Controllerschleifen, d.h. Regelungsschleifen mittels derer der Herstellungsprozess geregelt wird, des Run-to-Run-Verfahrens nicht unterbrochen oder mangelhaft mit Daten versorgt und gleichzeitig werden die am besten geeigneten Lose/Wafer gemessen.

Darüber hinaus ist es möglich die Messreihenfolge, d.h. die Reihenfolge in der die einzelnen Lose/Wafer in Testmessungen gemessen werden, den Erfordernissen des Run-to-Run-Verfahrens anzupassen. Hierdurch kann es nicht zu einer so genannten Überregelung des Herstellungsprozesses kommen. Diese Überregelung kann vorkommen, wenn die Messreihenfolge innerhalb der Lose nicht eingehalten wird. D.h. es stehen Wafer aus zwei Losen zum Messen an, welche Lose hintereinander prozessiert wurden. Die Wafer des zweiten Loses werden zuerst gemessen, was innerhalb eines SPC-Verfahrens gemäß dem Stand der Technik vorkommen kann. Aufgrund der Ergebnisse der Testmessungen an Wafern des zweiten Loses wird nun der vorausgehende Prozessschritt geregelt. Wenn nachfolgend nun Wafer des ersten Loses gemessen werden, sind diese noch mit alten Einstellungen des Herstellungsprozesses, bei welchen noch keine Änderungen aufgrund der Regelung durch die Ergebnisse der Messungen am zweiten Los, eingetreten sein können, hergestellt worden. Es können also noch keine Veränderungen in den Ergebnissen der Testmessungen aufgrund der Parameterveränderungen eingetreten sein. Die Run-to-Run Regelung erwartet jedoch schon die Auswirkungen der Regelung, da die Regelung bereits durchgeführt wurde. Demzufolge wird eine zweite Regelung durchgeführt. Es kommt zu einer Überregelung des Prozesses.

Erfindungsgemäß wird sichergestellt, dass eine Reihe von Losen einer Run-to-Run zu messenden Gruppe in der Reihenfolge ihrer Prozessierzeit gemessen werden.

Eine weitere Bedingung, welche mittels eines deterministischen Auswahlkriteriums eingehalten werden kann, ist, dass die zu sampelnden Lose anhand Kriterien getroffen werden, welche nach SPC- und Run-to-Run-Kriterien optimiert sind. Eine Möglichkeit der Optimierung ist zum Beispiel ein Kriterium, dass von einer Reihe von Losen mit hohen cp-Werten nicht das Los keiner Messung unterzogen werden soll, welches von einem Werkzeug kommt, welches das entsprechende Produkt lange nicht mehr erzeugt hat, und somit schon längere Zeit den Run-to-Run-Controller nicht aktualisiert hat, d.h. Ergebnisse von Testmessungen an den Run-to-Run-Controller gegeben hat, damit dieser den Herstellungsprozess gemäß dem Ergebnissen der Testmessung regelt. Somit wird sichergestellt, dass die Regelung in hinreichenden Maße die Einstellungen der Prozessparameter aktualisiert.

Mittels der Optimierung der Auswahlkriterien wird einerseits die Funktionsfähigkeit der Run-to-Run-Controller gewährleistet und verbessert und gleichzeitig werden die cpund cpk-Werte des Herstellungsprozesses verbessert.

Auch wenn die Erfindung im Weiteren an dem Beispiel eines Überwachungsverfahrens eines Wafer-Herstellungsverfahrens näher erläutert wird, ist darauf hinzuweisen, dass die Erfindung nicht darauf beschränkt ist, sondern in allen Überwachungsverfahren für Herstellungsverfahren, bei welchen im Herstellungsverfahren eines physikalischen Objektes Prozessparameter aufgenommen werden, eingesetzt werden kann, beispielsweise auch in der Pharma-Industrie bei dem Herstellen von pharmazeutischen Produkten.

Ein Ausführungsbeispiel der Erfindung ist in den Figuren dargestellt und wird im Weiteren näher erläutert.

Es zeigen:
Figur 1 ein Blockdiagramm, in welchem die allgemeine Organisation einer Chip-Produktionsanlage dargestellt ist;
Figur 2 eine Skizze einer Chip-Produktionsanlage, wobei der komplexe Materialfluss, d.h. der Weg eines Wafers/Loses durch die Chip-Produktionsanlage und die damit vorhandenen komplexen Prozessschritte dargestellt ist;
Figur 3 ein Blockdiagramm, in dem der Prozessdatenfluss bei dem Herstellen eines Wafers/Loses dargestellt ist; und
Figur 4 ein schematischer Ablaufplan eines erfindungsgemäßen Verfahrens.

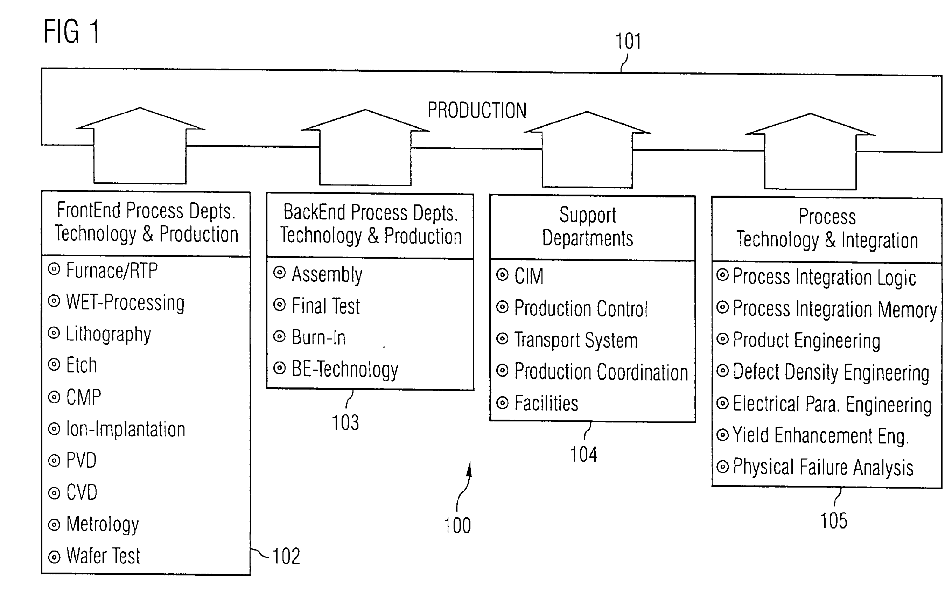

Einleitend wird in Fig. 1 in einem Blockdiagramm 100 schematisch die Organisation und der Aufbau einer Halbleiterchip-Produktionsanlage, für welche ein erfindungsgemäßes Verfahren zum Überwachen eines Herstellungsprozesses einer Mehrzahl von Wafern verwendet werden kann, erläutert.

Der gesamte Herstellungsprozess, in Fig. 1 mit einem ersten Block 101 bezeichnet, wird beispielhaft in vier Produktionsbereiche 102, 103, 104, 105 gruppiert,
einen ersten Bereich, in den die Front-End-Prozesse der Chip-Fertigung gruppiert werden (Block 102),
einen zweiten Bereich des Herstellungsprozesses, in den die Back-End-Prozesse gruppiert werden (Block 103),
einen dritten Bereich des Herstellungsprozesses, der den Support betrifft, das heißt die Unterstützung der einzelnen Herstellungsprozesse (Block 104),
ein vierter Bereich der die Prozesstechnologie und die Prozessintegration betrifft (Block 105).

Bei den Front-End-Prozessen 102 sind insbesondere folgende Prozesstechnologien sowie die für die Durchführung der entsprechenden Prozesse eingerichteten Vorrichtungen vorgesehen:
Ein Ofen zum Erhitzen des jeweiligen zu prozessierenden Wafers,
eine Vorrichtung zum Durchführen eines Kurzzeit-Temperverfahrens (Rapid Thermal Processing, RTP),
eine Vorrichtung zum Ätzen des Wafers, beispielsweise zum Nassätzen oder zum Trockenätzen,
eine Vorrichtung zum Reinigen, beispielsweise Waschen des Wafers,
eine Vorrichtung zur Durchführung unterschiedlicher Lithographieschritte,
eine Vorrichtung zum chemisch-mechanischen Polieren (Chemical Mechanical Polishing, CMP),
eine Einrichtung zur Durchführung einer Ionen-Implantation in vorgegebenen Bereichen des Wafers bzw. des jeweils zu fertigenden Chips,
Vorrichtungen zum Aufbringen von Materialien auf dem Wafer, beispielsweise Vorrichtungen zum Abscheiden von Materialien aus der Gasphase, das heißt beispielsweise Vorrichtungen zum Durchführen von Physical Vapour Deposition (PVD) oder Chemical Vapour Deposition (CDV), oder eine Vorrichtung zum epitaktischen Aufwachsen von Material auf einem Substrat, Metrologie-Vorrichtungen, d.h. Messvorrichtungen, Vorrichtungen zum Durchführen von Tests auf den jeweiligen Wafern.

Die Back-End-Prozesse betreffen insbesondere folgende Bereiche:
Den Zusammenbau der Chips in Gehäuse,
den Endtest des gefertigten und gehäusten Chips,
das Einbringen von Informationen, beispielsweise Produktinformation, in oder an das Gehäuse des jeweiligen Chips, sowie
allgemein die im Bereich des Back-Ends für gehäuste und ungehäuste Chip eingesetzten Technologien.

Der Support, das heißt die Prozessunterstützung betrifft insbesondere folgende Bereiche:
CIM,
Prozessüberwachung,
ein Transportsystem zur Auslieferung der gefertigten Halbleiterchips,
eine Koordination der Produktion,
die Unterstützung der jeweiligen Fertigungsstandorte.

Die Prozesstechnologie und die Prozessintegration betrifft insbesondere
die Prozessintegration von Logikbausteinen,
die Prozessintegration von Speicherbausteinen,
das Produkt-Engineering,
das Überwachen und Verbessern von Fehlerdichten bei der Herstellung,
das Überwachen elektrischer Parameter bei den hergestellten Produkten,
die Verbesserung der Ausbeute der hergestellten Chips,
eine physikalische Fehleranalyse.

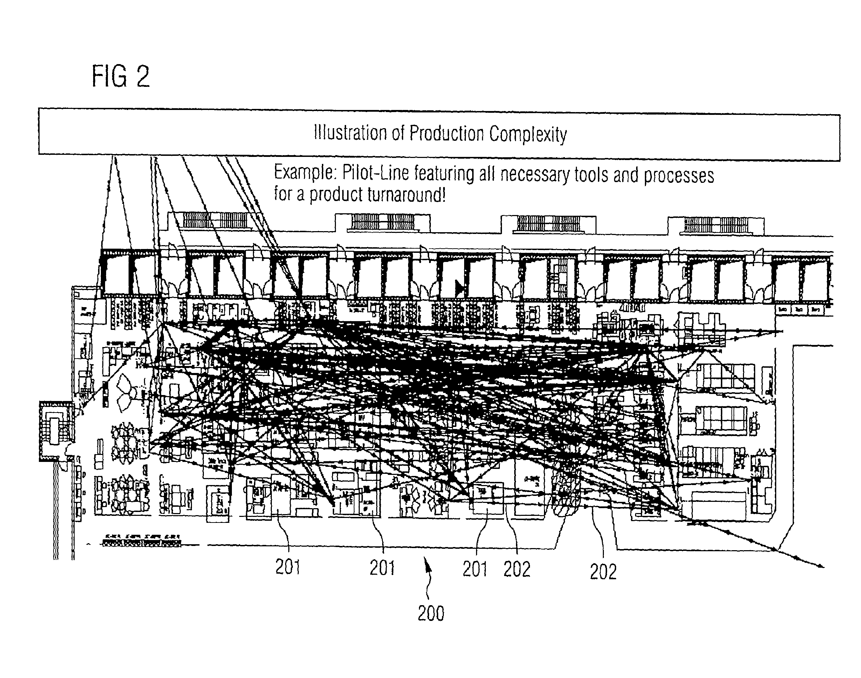

Fig. 2 zeigt eine Halbleiterchip-Produktionsanlage, anders ausgedrückt eine Halbleiterchip-Fabrik 200 mit einer Vielzahl von Halbleiterchip-Teil-Produktionsanlagen 201, welche eingesetzt werden zur Bearbeitung von Rohmaterialien, beispielsweise eines Siliziumwafers oder eines Wafers aus anderen Halbleiter-Materialien (Germanium, Gallium-Arsenid, Indium-Phosphid, etc.), um aus den Rohmaterialien Halbleiterchips zu fertigen.

Ein üblicher Herstellungsprozess zur Herstellung eines Halbleiterchips weist Hunderte von unterschiedlichen Prozessschritten auf, bei denen in unterschiedlicher Reihenfolge Lithographieschritte, Ätzschritte, CMP-Schritte, Schritte des Aufbringens von Materialien auf dem jeweiligen zu prozessierenden Wafer, oder auch Dotierungs- oder Implantationsschritte von Dotierungsatomen in den zu prozessierenden Wafer durchgeführt werden. Bei all diesem Prozessschritten werden Werte von Prozessparametern aufgenommen, welche einer späteren statistischen Analyse unterworfen werden können.

Somit ergeben sich die in Fig. 2 durch Linien 202 dargestellten Wege, welche den Weg eines Wafers oder eines Loses durch die Halbleiterchip-Produktionsanlage 200 darstellen. In der Halbleiterchip-Produktionsanlage 200 ist eine Vielzahl von Sensoren, welche den jeweiligen Teil-Produktionsanlagen 201 zugeordnet sind und eine noch größere Menge von Prozessdaten (Rohdaten) werden aufgenommen, welche jeweils von den Sensoren erfasst werden und, wie im Weiteren näher erläutert wird, verarbeitet werden. Ein jeweiliger Sensor kann in eine jeweilige Maschine integriert sein (integrierter Sensor) oder separat an eine jeweilige Maschine angebaut sein (externer Sensor).

Im Weiteren werden die Teil-Produktionsanlagen 201 auch als Maschinen 201 bezeichnet.

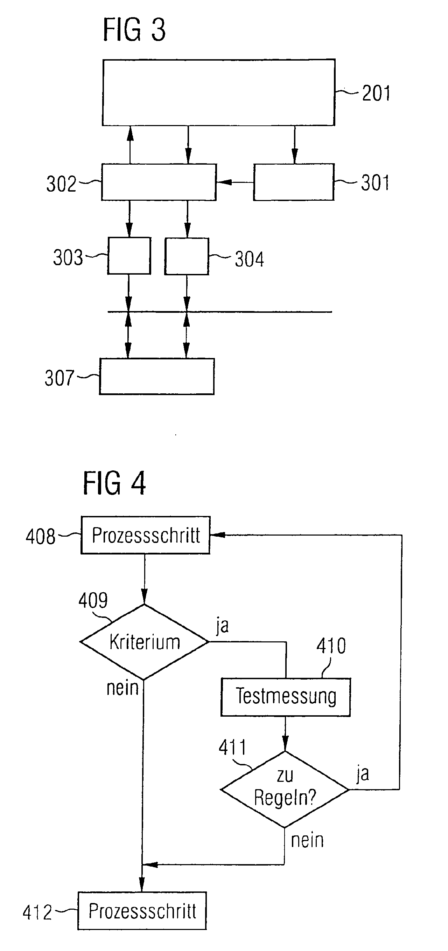

Fig.3 zeigt beispielhaft den Datenfluss für Prozessdaten, welche an einer Maschine 201 mittels eines integrierten oder mittels eines externen Sensors 301. Jeder Sensor 301, wobei eine beliebige Anzahl integrierter und/oder externer Sensoren vorgesehen sein können, erfasst die jeweils für ihn vorgegebenen Parameter der Maschine 201, beispielsweise physikalische oder chemische Zustände in einer Prozesskammer, die Position eines Roboterarms, etc. Beispiele für Prozessparameter bei der Herstellung eines Wafers sind zum Beispiel die Dejustierung, d.h. die PositionierungsUngenauigkeit, innerhalb eines Positionierungsschrittes, Temperatur während eines Prozessschrittes, Gasfluss während eines Prozessschrittes, Zeitdauer eines Prozessschrittes oder der Druck während eines Prozessschrittes.

Der Sensor 301 ist über eine SECS-Schnittstelle 302, die eingerichtet ist zur Datenkommunikation gemäß den SECS-Standards mit einem lokalen Kommunikationsnetz (Local Area Network, LAN) 306 gekoppelt.

Gemäß den SECS-Standards werden von dem Sensor 301 und der SECS-Schnittstelle 302 Dateien gemäß dem PDSF-Format (Process Data Standard Format) erzeugt, im Weiteren auch bezeichnet als PDSF-Dateien 303 sowie Protokolldateien 304, wobei die PDSF-Dateien 303 und die Protokolldateien 304 als Daten in einem Speicher 307 gespeichert werden.

Die PDSF-Dateien 303 enthalten z.B. analoge Daten von unterschiedlichen Kanälen, das heißt von unterschiedlichen internen (d.h. integrierten) und/oder externen Sensoren 301, welche an einer Maschine 201 angebracht sein können. Die erzeugten Prozessdaten werden in dem Speicher 307 gespeichert.

Nachdem in den Figuren 1 bis 3 eine schematische Übersicht über einen Herstellungsprozess eines Wafers und ein Verarbeiten von gemessenen Prozessparametern dargestellt wurde, wird in Fig. 4 nun ein schematischer Ablaufplan eines Verfahrens zum Überwachen und Regeln eines derartigen Herstellungsprozesses gemäß einem Ausführungsbeispiel der Erfindung gegeben.

Das Überwachen und Regeln des Herstellungsprozesses wird vorzugsweise mittels eines Steuerrechners durchgeführt. Mittels diesem Steuerrechner wird insbesondere die Regelung der einzelnen Prozessschritte, d.h. der Prozessparameter der einzelnen Prozessschritte durchgeführt. Ferner wird mittels des Steuerrechners auch die Auswahl der Stichproben, welche einer Testmessung unterzogen werden sollen, gemäß deterministischer Auswahlkriterien getroffen.

In einem Prozessierungsschritt 408 des oben beschriebenen Herstellungsverfahrens, welcher mittels des erfindungsgemäßen Verfahrens geregelt wird, werden eine Mehrzahl von Zwischenprodukten eines Wafer-Herstellungsprozesses erzeugt. Die Mehrzahl von Wafern werden im Herstellungsprozess logistisch zu einem Los zusammengefasst. Alle Wafer, welche einem Los angehören, werden mittels der gleichen Prozessierungsschritte auf den gleichen Maschinen usw. hergestellt. Sie haben also eine gleiche Herstellungsgeschichte. Diese Herstellungsgeschichte spiegelt sich auch in den im Speicher 307 gespeicherten Prozessdaten wider. Gleichartige Zwischenprodukte (halbfertige Wafer) können unter Umständen auch eine andere Herstellungsgeschichte haben. Z.B. kann ein Prozessierungsschritt auf verschiedenen Maschinen durchgeführt werden und somit kann ein gleichartiges Zwischenprodukt mit verschieden Herstellungshistorien produziert werden.

Erfindungsgemäß wird nun die Reihenfolge der einzelnen Wafer innerhalb eines Loses festgehalten und auch die Reihenfolge einzelner Lose untereinander festgehalten.

Wenn auf Grund dieser Lose der Prozessierungsschritt 408 geregelt werden soll, muss eine Stichprobe an Wafern und/oder Losen von Wafern ausgewählt werden, welche einer Testmessung zum Feststellen der Qualität des Herstellungsschrittes unterzogen wird. Diese Auswahl erfolgt erfindungsgemäß mittels deterministischer Auswahlkriterien, welche einerseits die Bedürfnisse eines herkömmlichen in-line-SPC-Verfahrens erfüllen, welche im allgemeinen einfach eine vorgegebene Anzahl von Wafern aus dem Los, sind. Andererseits berücksichtigt die gemäß deterministischen Auswahlkriterien ausgewählte Stichprobe auch die Notwendigkeit des Verfahrens zum Regeln des Herstellungsprozesses, eines Run-to-Run-Verfahrens.

Erfüllt ein Los/Wafer die Auswahlkriterien für die Stichprobenauswahl im Schritt 409, so wird das entsprechende Los für Testmessungen vorgesehen. Auswahlkriterien können zum Beispiel sein, dass das betreffende Los schon zur Regelung eines vorhergehenden Prozessschrittes verwendet wurde, und die Regelung des nachfolgenden Prozessschrittes 408 mit der Regelung des vorrangehenden Prozessierungsschrittes gekoppelt ist. Ein weiteres Auswahlkriterium kann sein, dass die Wafer des betreffenden Loses auf einer Maschine oder Werkzeug hergestellt wurden, welche Maschine oder Werkzeug schon über eine längere Zeit nicht mehr durch das Regelungsverfahren geregelt wurde. Nachfolgend werden die Testmessungen, welche für die Regelung des Herstellungsverfahrens benötigt werden, in Schritt 410 durchgeführt. Diese Testmessungen, welche für das Regelungsverfahren (Run-to-Run-Verfahren) nötig sind, sind gleichzeitig als Messungen für das in-line-SPC-Verfahren verwendbar, da erfindungsgemäß bei den Auswahlkriterien für die Stichprobe, die jeweiligen Auswahlkriterien sowohl des in-line-SPC-Verfahrens als auch die Auswahlkriterien des Run-to-Run-Verfahrens berücksichtigt werden.

Erfindungsgemäß wird außerdem die Reihenfolge der Lose bzw. der einzelnen Wafer innerhalb eines Loses berücksichtigt. Somit kann es nicht zu einem so genannten Überregeln des Herstellungsprozesses kommen. Eine Überregelung kann dann vorkommen, wenn zwei Lose von Wafern in umgekehrter Reihenfolge ihrer Prozessierung in einer Testmessung gemessen werden. Wird zuerst ein späteres Los bzw. Wafer dieses späteren Loses im Rahmen des Run-to-Run-Verfahrens gemessen und auf grund der Ergebnisse dieser Messungen der vorhergehende Prozessierungsschritt geregelt, so kann diese Regelung auf ein vorher prozessiertes Los von Wafern keine Auswirkung haben. Da das eigentlich früher prozessierte Los jedoch erst nach dem später prozessierten Los der Testmessung für das Run-to-Run-Verfahren vermessen wird, wird eine erneute Regelung durchgeführt, weil das Run-to-Run-Verfahren in der Auswertung der Ergebnisse der Testmessungen davon ausgeht, dass die Regelung für die Produktion dieses Loses schon durchgeführt war. Die Auswertung ergibt also einen weiteren Regelungsbedarf für den Herstellungsschritt. Es kommt zu einer Überregelung des Prozesses. Um solch eine Überregelung zu verhindern, wird erfindungsgemäß die Prozessund die Messreihenfolge der einzelnen Lose beachtet.

Nachfolgend zu der Testmessung analysiert eine Auswerteeinheit 411 des Run-to-Run-Verfahrens die Ergebnisse der Testmessungen anhand vorgegebener Kriterien, z.B. Grenzwerte oder Produktqualitäten, welche eingehalten werden müssen, ob eine Regelung des Prozessschrittes 408 nötig ist oder nicht. Im Falle dass eine Regelung nötig ist, wird diese Regelung für den Prozessschritt 408 durchgeführt, d.h. im Allgemeinen werden Prozessparameter des Prozessierungsschrittes geändert.

Die Wafer bzw. das Los mit der Mehrzahl von Wafern, welches den Testmessungen unterzogen wurde, wird anschließend an die abgeschlossenen Testmessungen wiederum in den normalen Herstellungsprozess integriert. Wenn die Ergebnisse und die Auswertung dieser Ergebnisse jedoch ergeben, dass eventuell gesetzte Grenzwerte für Produktqualitäten nicht eingehalten werden, können diese Wafer bzw. das Los von Wafern jedoch auch den Schritten unterzogen werden, welche das in-line-SPC-Verfahren für solch einen Fall vorsieht. Z.B. können diese Wafer bzw. das Los von Wafern aus dem herkömmlichen Herstellungsprozess entfernt werden, oder einer Nachbearbeitung unterzogen werden.

Wird ein Los im Schritt 409 nicht als Stichprobe ausgewählt, welche für Testmessungen herangezogen werden soll, so verbleibt es im normalen Herstellungsprozess und wird mittels eines nächsten Prozessierungsschritt 412 weiterprozessiert.

Zusammenfassend schafft die Erfindung ein Verfahren, bei welchem Auswahlkriterien für die Auswahl einer Stichprobe von Losen von Wafern oder Wafern, die Auswahlkriterien eines in-line-SPC-Verfahrens und eines Run-to-Run-Verfahrens, welches einen Herstellungsprozesses eines physikalischen Objektes regelt, kombiniert. Mittels dieser kombinierten Auswahlkriterien, werden mittels einer minimalen Anzahl von durchzuführenden Testmessungen die Notwendigkeiten sowohl des in-line-SPC-Verfahrens als auch des Run-to-Run-Verfahrens erfüllt. Die Anzahl der Messungen wird verringert, da redundante Messungen vermieden werden. Auch wird mittels des erfindungsgemäßen Verfahrens sichergestellt, dass alle Messungen, welche an einem Wafer oder Los von Wafern durchgeführt werden müssen, um alle für das Run-to-Run-Verfahren benötigten Messwerte zu erhalten, durchgeführt werden. Es ist erfindungsgemäß weiterhin sichergestellt, dass die einzelnen Lose von Wafern in der Prozessierung der Testmessung nicht in umgekehrter Reihenfolge abgearbeitet werden, d.h. die Reihenfolge der Prozessierung und die Reihenfolge in der eventuelle Testmessungen durchgeführt werden ist die gleiche. Hierdurch kann es nicht zu einer so genannten Überregelung des Herstellungsprozesses kommen. Auch wird durch die deterministischen Auswahlkriterien sichergestellt, dass es nicht durch fehlende Werte, d.h. Ergebnisse von Testmessungen, zu einem Versagen des Run-to-Run-Verfahrens, bzw. der Algorithmen mittels deren das Run-to-Run-Verfahren durchgeführt wird, kommt.

Im Rahmen der Erfindung wird ein integrales Advanced Process Control (APC) geschaffen, d.h. ein übergreifendes Regelwerk, welches ein Verfahren zum Regeln eines Herstellungsprozesses eines physikalischen Objektes, z.B. ein Run-To-Run-Verfahren, und ein Verfahren der Produktion, z.B. ein SPC-Verfahren, welches Sampling oder Losauswahl für Testmessungen zum Bestimmen der Produktionsqualität bestimmt, vereinigt. Ferner wird mittels Einbindens der Regeln des Regelwerkes in eine rechnergestütztes Verfahren zum Überwachen und Regeln des Herstellungsverfahrens eine flexible und automatische Verarbeitung gewährleistet und es wird sichergestellt, dass sowohl das Verfahren zum Regeln eines Herstellungsprozesses als auch das Verfahren der Produktion durchgeführt und auch angepasst werden können.

In diesem Dokument sind folgende Dokumente zitiert:
[1] GB 2 347 522
[2] US 6 263 255

### Bezugszeichenliste

- 100: schematisches Blockdiagramm eines Aufbaus einer Halbleiter-Produktionsanlage
- 101: Block eines gesamten Herstellungsprozesses
- 102: Block eines ersten Produktionsbereiches
- 103: Block eines zweiten Produktionsbereiches
- 104: Block eines dritten Produktionsbereiches
- 105: Block eines vierten Produktionsbereiches
- 200: Halbleiterchip-Produktionsanlage
- 201: Vielzahl von Halbleiterchip-Teil-Produktionsanlagen
- 202: Weg eines Wafers oder Loses durch die Halbleiterchip-Produktionsanlage
- 201: Maschine
- 301: Sensor
- 302: SECS-Schnittstelle
- 303: PDSF-Datei
- 304: Protokolldatei
- 306: lokales Kommunikationsnetz (LAN)
- 307: Speicher
- 408: Prozessierungsschritt
- 409: Abfrage des Auswahlkriteriums
- 410: Testmessung
- 411: Auswerteeinheit
- 412: nächster Prozessierungsschritt

## Patentansprüche

1. Run-to-Run-Verfahren zum rechnergestützten Überwachen und Regeln eines Herstellungsprozesses einer Mehrzahl von Wafern,
bei dem die Wafer mindestens einem Herstellungsschritt unterzogen werden;
bei dem gemäß einem deterministischen Ausfallkriterium mindestens einer der prozessierten Wafer so markiert wird, dass er einer in-line-SPC-Messung unterzogen werden kann;
bei dem basierend auf dem Ergebnis der in-line-SPC-Messung des Wafers der Herstellungsprozess geregelt wird, und
bei dem mindestens ein sowohl für das Run-to-Run-Verfahren als auch für das in-line-SPC-Verfahren notwendiger Wafer gemäß dem deterministischen Auswahlkriterium ausgewählt wird.

2. Verfahren gemäß Anspruch 1, bei dem das deterministische Auswahlkriterium mittels Regeln bestimmt wird.

3. Vorrichtung zum Überwachen und Regeln eines Herstellungsprozesses einer Mehrzahl von Wafern, mit einem Prozessor, der derart eingerichtet ist, dass folgende Verfahrensschritte eines Run-to-Run-Verfahrens durchführbar sind:
Durchführen mindestens eines Herstellungsschrittes an den Wafern;
derartiges Markieren mindestens eines der Wafer gemäß einem deterministischen Auswahlkriterium, dass es einer in-line-SPC-Messung unterzogen werden kann, wobei mindestens ein sowohl für das Run-to-Run-Verfahren als auch für das in-line-SPC-Verfahren notwendiger Wafer gemäß dem deterministischen Auswahlkriterium ausgewählt wird; und
Regeln des Herstellungsprozesses basierend auf dem Ergebnis der in-line-SPC-Messung.

4. Computerlesbares Speichermedium, in dem ein Programm zum Überwachen und Regeln eines Herstellungsprozesses einer Mehrzahl von Wafern gespeichert ist, wobei das Überwachen und Regeln mittels eines Run-to-Run-Verfahrens durchgeführt wird, das, wenn es von einem Prozessor ausgeführt wird, folgende Verfahrensschritte ausführt:
Durchführen mindestens eines Herstellungsschrittes an den Wafern;
derartiges Markieren mindestens eines der prozessierten Wafer gemäß einem deterministischen Auswahlkriterium, dass es einer in-line-SPC-Messungunterzogen werden kann, wobei mindestens ein sowohl für das Run-to-Run-Verfahren als auch für das in-line-SPC-Verfahren notwendiger Wafer gemäß dem deterministischen Auswahlkriterium ausgewählt wird; und
Regeln des Herstellungsprozesses basierend auf dem Ergebnis der in-line-SPC-Messung.

5. Programm-Element zum Überwachen und Regeln eines Herstellungsprozesses einer Mehrzahl von Wafern, wobei das Überwachen und Regeln mittels eines Run-to-Run-Verfahrens durchgeführt wird, das, wenn es von einem Prozessor ausgeführt wird, folgende Verfahrensschritte ausführt:
Durchführen mindestens eines Herstellungsschrittes an den Wafern;
derartiges Markieren mindestens eines der prozessierten Wafern gemäß einem deterministischen Auswahlkriterium, dass es einer in-line-SPC-Messungunterzogen werden kann, wobei mindestens ein sowohl für das Run-to-Run-Verfahren als auch für das in-line-SPC-Verfahren notwendiger Wafer gemäß dem deterministischen Auswahlkriterium ausgewählt wird; und
Regeln des Herstellungsprozesses basierend auf dem Ergebnis der in-line-SPC-Messung.
